# EUROPEAN PATENT SPECIFICATION

(11) **EP 3 526 613 B1**
(45) Date of publication and mention of the grant of the patent: **15.07.2020**
(21) Application number: 17840598.1
(22) Date of filing: 23.11.2017
(51) Int. Cl.: G01R 15/16

(54) **CONSTRUCTIVE SYSTEM REGARDING A CAPACITIVE SENSOR**
KONSTRUKTIONSSYSTEM IN BEZUG EINES KAPAZITIVEN SENSOR
SYSTÈME DE CONSTRUCTION CONCERNANT UN CAPTEUR CAPACITIF

(30) Priority: 24.11.2016 IT 201600118863
(43) Date of publication of application: 21.08.2019
(73) Proprietor: G & W Electric Company, Bolingbrook IL 60440 (US)
(72) Inventor: PERETTO, Lorenzo, I-45025 Fratta Polesine (Rovigo) (IT); BAUER, Alberto, P.O. Box 11855 Dubai (AE)
(74) Representative: Gustorf, Gerhard
(86) International application number: PCT/IT2017/000263
(87) International publication number: WO 2018/096567

(56) References cited:
- EP-A1- 2 887 074
- WO-A1-2010/070693
- GB-A- 1 058 890
- US-A1- 2011 121 842
- US-A1- 2016 245 845

## Description

### Technical Filed

The present invention relates to a constructive system for creating a capacitive sensor able to estimate the voltage value of a live element. The most relevant prior art is disclosed in US 2016/245845 A1 of the applicant.

More in particular but not exclusively, the present invention relates to a constructive system of the aforesaid type, in which said live element is arranged inside the same capacitive sensor.

Furthermore, the present invention relates to a constructive system of the aforesaid type, in which said constructive system can also be used to create a combined voltage/current sensor, in which said combined voltage/current sensor is also able to detect a magnetic field generated by said live element arranged inside said capacitive sensor.

Still the present invention relates to a constructive system of the aforesaid type, particularly but not exclusively indicated to create a termination for a low, medium or high voltage cable, wherein said termination will be able to estimate the value of the voltage of said cable.

Again the present invention relates to a constructive system of the aforesaid type, particularly but not exclusively indicated to create a termination for a low, medium or high voltage cable, wherein said termination will be able to estimate the value of the voltage of said cable and of the magnetic field generated by said cable, in order, for example, to estimate the current of the same cable.

### Background of the Invention

Currently, known construction systems relating to the capacitive voltage sensors or the combined voltage/current sensors have a series of drawbacks.

A first drawback is due to the fact that said known construction systems are not suitable for creating a capacitive sensor, in which said capacitive sensor is able to estimate the voltage value of a live conductor without suffering the influences of the surrounding electric fields generated by other live conductors arranged nearby.

A second drawback is due to the fact that said known construction systems are not suitable for creating a combined voltage/current sensor, in which said combined voltage/current sensor is be able to estimate the voltage value of a live conductor without suffering influences of the surrounding electric fields generated by other conductors located nearby.

A third drawback is due to the fact that said known construction systems are not suitable for creating a termination for a low, medium or high voltage cable, wherein said termination is able to estimate the voltage value of a live cable without being subjected to the influences of the surrounding electric fields generated by other live conductors arranged nearby.

A fourth drawback is due to the fact that said known construction systems are laborious to manufacture.

A fifth drawback is due to the fact that in known construction systems the dielectric material resin disposed around the components forming the sensor or forming the termination includes vacuoles (air bubbles), with consequent phenomena of unwanted partial discharges.

A sixth drawback is due to the fact that in the known construction systems the dielectric material resin arranged around the components forming the sensor or forming the termination is detached with respect to said components, with consequent phenomena of unwanted partial discharges.

A seventh drawback is due to the fact that in the known construction systems the aforementioned resin is not perfectly adherent and/or not perfectly clinging and/or jointed with respect to the components that form the sensor or which form the termination, therefore, as a result of aging, there are detachments between said resin and the aforementioned elements, with consequent phenomena of unwanted partial discharges. This drawback is particularly present when the sensor or termination is used in an environment where the operating temperature (hot/cold) varies cyclically.

An eighth drawback is due to the fact that in the known construction systems the operations for applying the relative termination with respect to a terminal cable are very laborious.

A ninth drawback is due to the fact that, by means of known construction systems, after having applied the relevant sensor with respect to a cable or after having applied the relative termination with respect to a terminal cable on-site calibration is necessary.

### DESCRIPTION OF THE INVENTION

The object of the present invention is to solve the above mentioned problems. The invention, which is characterized by the claims, solves the problem of creating a constructive system for the estimation of the value of the voltage of a live element, wherein said system extends along an axis defined longitudinally, in which said system with respect to said longitudinal axis defines a vicinal end and a distal end, in which said system is characterized by the fact that it comprises a first tubular element, a second tubular element, an electric field sensor and a mass of dielectric material; by the fact that said first tubular element carries out the function of source electrode; by the fact that said first tubular element is connected by means of conductive coupling with said live element; by the fact that said second tubular element carries out the function of shielding electrode; by the fact that said second tubular element is connected to the ground; by the fact that said electric field sensor carries out the function of detecting the electric field generated by said first tubular element; by the fact that said mass of dielectric material carries out the function of incorporating and positioning said elements between them; by the fact that said first tubular element is arranged coaxial with respect to said longitudinal axis; by the fact that said second tubular element is arranged coaxial with respect to said longitudinal axis; by the fact that said electric field sensor is positioned between said two tubular elements; by the fact that said electric field sensor is electrically insulated with respect to said first tubular element and with respect to said second tubular element.

### BRIEF DESCRIPTION OF THE DRAWINGS

The following description of the construction system proposed by the present invention, in the various embodiments, is given by ways of non-limiting example and made with reference to the attached drawings, in which:
Figure 1 illustrates schematically the construction system object of the present invention;
Figure 1A schematically illustrates the construction system object of the present invention applied to a terminal cable in order to form a termination;

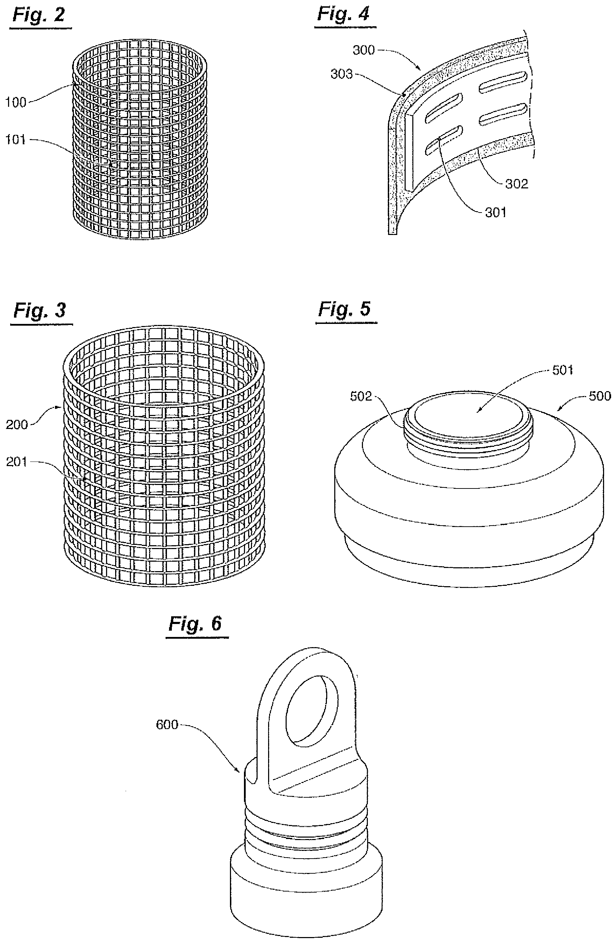

Figures 2, 3, 4, 5, and 6 illustrate schematically some details of the construction system object of the present invention.

### PREFERRED MANNER OF IMPLEMENTING THE INVENTION

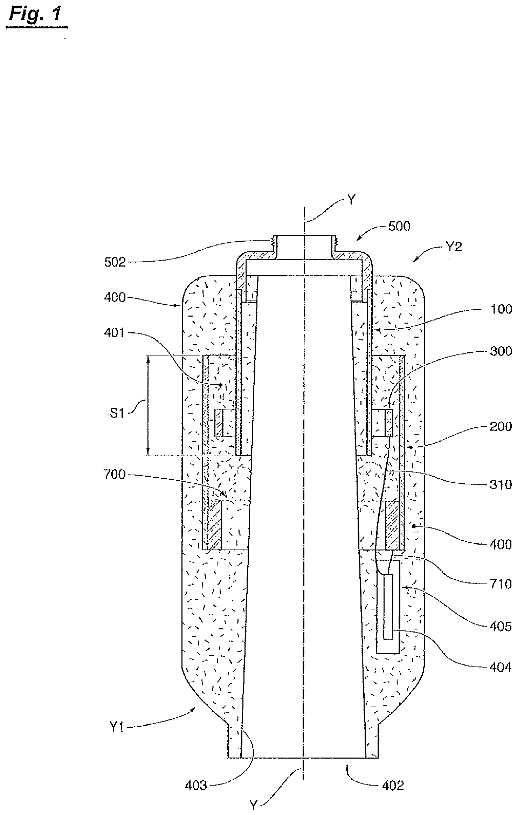

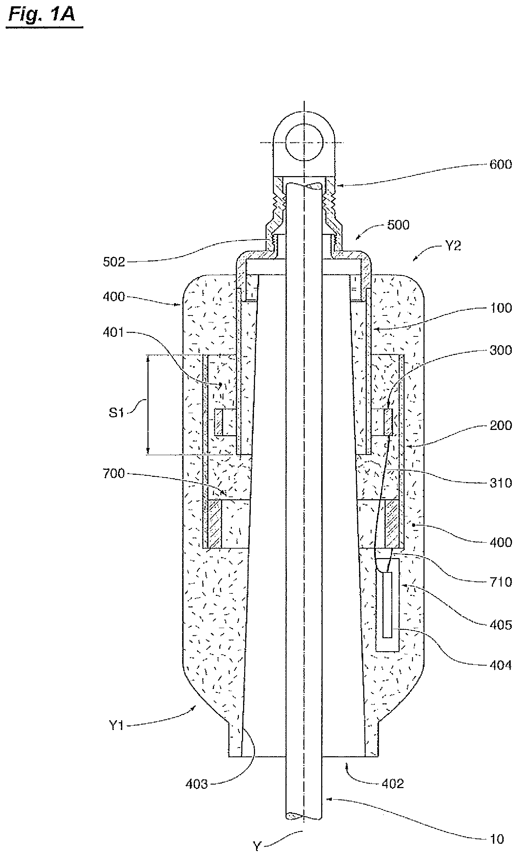

With reference to Figures 1 and 1A, they illustrate the construction system object of the present invention for measuring the voltage value of a live element, such as, for example, see fig. 1A, of a live cable 10 which extends along a longitudinal axis **Y**.

The same construction system, with respect to said longitudinal axis **Y,** defines a proximal/end portion **Y1** and a distal portion/end **Y2** and, substantially, it comprises: a first tubular element **100;** a second tubular element **200;** an electric field sensor **300;** and a mass of dielectric material **400.**

The first tubular element **100** acts as a source electrode, it is connected by conductive coupling with said live element **10,** so that said first tubular element **100** will have an identical potential with respect to the potential of the live element **10,** wherein the latter, for example, can be a cable with a live central metallic core and an external insulating material.

With reference to Figure 1A, the first tubular element **100,** being in electric voltage as aforesaid, also acts as a shielded electrode, as it provides for shielding the electric field sensor **300** with respect to the electric field lines emitted by the conductor **10,** i.e. it inhibits to the electric field lines generated by the conductor **10** to close on the electric field sensor **300,** thus ensuring that the intensity of the electric field lines closed on the sensor **300** will be independent from the cross-section and/or the type of the conductor **10.**

The second tubular element **200** acts as a shielding electrode and for this purpose it is connected to ground in any manner, or if it is not connected to ground it is connected to a known electrical potential constant over time.

The electric field sensor **300** performs the function of detecting the electric field generated by said first tubular element **100,** forming a capacitive coupling between said first tubular element **100** (which acts as the first armature) and said field sensor **300** (which acts as a second armature).

The mass of dielectric material **400** performs the function of incorporating and positioning said elements **100, 200, 300** between them.

The first tubular element **100** and the second tubular element **200** are coaxial with respect each other and coaxial with respect to said longitudinal axis **Y,** so as to form interspaces **401** of dielectric material having a certain axial extension between them.

The electric field sensor **300** is positioned between said two tubular elements **100, 200,** preferably within said interspace **401,** and said electric field sensor **300,** is electrically insulated with respect to said first tubular element **100** and with respect to said second tubular element **200.**

With reference to the mass of dielectric material **400** which incorporates the components **100, 200** and **300,** it forms and comprises a through hole **402** having a certain circumference **403,** wherein said hole **402** is arranged coaxially with respect to the longitudinal axis **Y,** in which, see fig. 1A, the live element **10** will be disposed within said hole **402.**

### First perforated electrode tubular element

Preferably, said first tubular element **100** is provided with first through holes **101,** wherein said first through holes **101** have a width selected according to the type of resin and other factors and, more particularly, a minimum width such as to allow the passage of the resin through them during casting operations, and a maximum width such as to guarantee the desired shielding effect.

Preferably each opening of said through holes **101** defines an area comprised between a minimum of 0.1 mm² and a maximum of 3 mm².

### Second perforated shielding tubular element

Preferably, said second tubular element **200** is provided with second through holes **201,** wherein said second through holes **201** have a width selected according to the type of resin and other factors and, more particularly, a minimum width such as to allow the passage of the resin through them during casting operations, and a maximum width such as to guarantee the desired shielding effect.

Preferably each opening of said through holes **201** defines an area comprised between a minimum of 0.1 mm² and a maximum of 3 mm².

### Electric Field Sensor 300 -

Preferably, said electric field sensor **300** is provided with through holes **301,** in which said through holes **301** have a width selected according to the type of resin and other factors and, more particularly, a minimum width such as to allow the passage of the resin through them during casting operations, and a maximum width such as to guarantee the desired shielding effect.

Preferably, each opening of said through holes **301** defines an area comprised between a minimum of 0.1 mm² and a maximum of 3 mm².

### Electric field sensor 300 - Foil of PCB (printed circuit board)

Preferably, said electric field sensor **300** comprises at least a first inner lamina **302** and a second outer lamina **303** superimposed and joined together, wherein said first inner lamina **302** is made of an electrically conductive material, in which said second external lamina **303** is made by an electrically insulating material, and in which, again preferably, said second outer layer **303** is jointed with respect to the inner face of the second shielded tubular element **200.**

More particularly, said second outer layer **303** of insulating material has technical characteristics such as to electrically insulate the inner lamina **302** of the electric field sensor with respect to the second shielding tubular element **200** and, in this context, said electric field sensor **300** can be realized by a foil of PCB (printed circuit board) or by means of a similar element, preferably provided with through holes, as indicated above.

### Cover 500

With reference to the figures, said construction system can further comprise a lid element **500** in the form of an upside-down cup equipped with through axial hole **501,** in which said cover element **500** is electrically conductive applied near the distal portion of the first tubular element **100** with the through hole **501** coaxial with respect to the longitudinal axis Y.

### Cable Terminal 600

Preferably, said lid element **500** is provided with coupling means **502,** in which said coupling means **502** are able for coupling in a conductive manner with a cable terminal **600,** wherein said cable terminal **600** is designed to couple in a conductive manner (for example by crimping with the live element **10,** so as to create, through said cable terminal **600** and said lid element **500,** a conductive coupling between said live element **10** and the first tubular element **100,** in which the latter will be thus live placed at same voltage of the cable **10.**

### Room 405 into the Mass 400

With reference to the mass of dielectric material **400,** it preferably forms a room **405,** preferably formed by a box-like body of conductive material connected to the ground, therefore shielding, incorporated in the resin **400,** wherein said room **405** contains an electronic processing circuit **404,** wherein said processing circuit **404** is able to process the signals received by the electric field sensor **300** by means of the cable **310,** as well as, optionally, the signals received by a Rogowski coil **700,** better described later, by means of a cable **710.**

### Rogowski 700 coil

The same constructive system object of the present invention can further comprise a Rogowsky coil **700,** which has its axis **Y_700** positioned coaxially with respect to the longitudinal axis **Y** of the constructive system.

Preferably, said Rogowsky coil **700** comprises an outer shield connected to the ground, such as for example a shielding connected in a conductive manner with said second shielding tubular element **200** and, more preferably, said Rogowsky coil **700** is positioned inside the second tubular element **200,** in an axial position between said electric field sensor **300** and the proximal end of the second tubular element **200.**

With this particular configuration, the Rogowski **700** coil performs a high shielding able to protect the electric field sensor **300.**

### Geometries

With reference to Figure 1, it illustrates a particular but non-limiting configuration in which said first tubular element **100** has a certain axial extension and a determined first axial position, wherein said second tubular element **200** has a certain axial extension and a determined second axial position, in which through said two tubular elements **100** and **200** a first axial segment **S1** is configured, wherein said first segment **S1** comprises the first tubular element **100** and also the second tubular element **200** axially and radially spaced from each other, wherein in said first segment **S1** is configured a zone **401** of dielectric material positioned between said two tubular elements **100** and **200.**

With reference to said configuration, preferably said electric field sensor **300** is positioned within said first segment **S1.**

Still with reference to said configuration, preferably, an externally shielded Rogowsky coil **700** is positioned between the proximal end of the electric field sensor **300** and the proximal end of the tubular element **200.** Furthermore, the aforementioned shielding of the Rogowsky **700** is connected to the ground in any possible manner, such as, for example, connected and/or adhering in a conductive manner with the second tubular element **200,** in which this latter is connected to the ground.

### Advantages

By the constructive system of the present invention, only the electric field lines generated by the first tubular element (source electrode) **100** will be closed on the electric field sensor **300,** while any other unwanted electric field lines, such as for example the electric field lines generated by other live conductors arranged nearby, will not be able to close on said field sensor **300** being the second shielded tubular element **200** connected to the ground.

With reference to the distal portion **Y2** of the constructive system, the cited unwanted field lines will not be able to close on the field sensor **300,** as the first tubular element **100,** placed in electric voltage, performs a shielding action that prevents said unwanted field lines from entering through the distal end **Y2** of the system.

With reference to the neighboring portion **Y1** of the construction system, the cited unwanted field lines will not be able to close on the field sensor **300,** as the shield connected to the ground of the Rogowsky coil **700** performs a shielding action which prevents said unwanted field lines from entering through the proximal end **Y1** of the system.

With reference to Figure **1A****,** the first tubular element **100,** being in electric voltage, provides for shielding the electric field sensor **300** with respect to the field lines emitted by the conductor **10,** ensuring that the intensity of the electric field lines closed on the sensor **300** will be independent either from the section and from the type of the conductor **10.**

With reference to Figure 1A, by means of the construction system object of the present invention, a termination can be created for a low, medium or high voltage cable **10,** wherein said termination is adapted to estimate the value of the voltage relative to said live cable **10,** as well as, if required, the estimate of the value of the current regarding said cable **10.**

By the constructive system object of the present invention it is possible to create a voltage sensor, or a combined voltage/current sensor, as well as a termination suitable for carrying out the function of voltage sensor or the function of voltage/current sensor, in which said sensor is very simple to realize and easy to use.

Again by means of the construction system object of the present invention, by virtue of the through holes, ref. **101** for the tubular **100,** ref. **201** for the tubular **200,** ref. **301** for the field sensor **300,** during the casting operations of the resin in its liquid/pasty state, said resin can pass and flow through said holes and position itself within said holes, obviating the formation of vacuoles and improving the incorporation, adhesion, gripping and positioning action of the individual components that form the construction system, avoiding any undesired detachment when the resin will be solid, thus solving the above-mentioned problems regarding the partial discharges.

Also by means of the construction system object of the present invention there will not be necessary any calibrations after the sensor or termination positioning with respect to the live element **10,** as the characteristics regarding the capacitive coupling between the first tube **100** and the electric field sensor **300** will not change in relation to the application of the system on live cables **10** having a greater or lesser cross section.

## Claims

1. Constructive system for the estimation of the value of the voltage of a live element (**10**), wherein said system extends along an axis (**Y**) defined longitudinally, in which said system with respect to said longitudinal axis (**Y**) defines a vicinal end and a distal end, comprising a first tubular element (**100**), a second tubular element (**200**), an electric field sensor (**300**) and a mass of dielectric material (**400**); **wherein** said first tubular element (**100**) carries out the function of source electrode and is connected by means of conductive coupling with said live element (**10**); **wherein** said second tubular element (**200**) carries out the function of shielding electrode and is connected to earth or to a known potential; **wherein** said electric field sensor (**300**) carries out the function of detecting the electric field generated by said first tubular element (**100**); **wherein** said mass of dielectric material (**400**) carries out the function of incorporating and positioning said elements (**100, 200, 300)** between them; **wherein** said first tubular element (**100**) is arranged coaxially with respect to said longitudinal axis (**Y**) and said second tubular element (**200**) is arranged coaxially with respect to said longitudinal axis (**Y**); **wherein** said electric field sensor (**300**) is positioned between said two tubular elements (**100, 200**) and is electrically insulated with respect to said first tubular element (**100**) and with respect to said second tubular element (**200**).

2. Constructive system according to claim 1, **characterized by the fact that** said first tubular element (**100**) also carries out the function of screen electrode able to screen the sensor (**300**) of electric field with respect to the field lines of the electrical field emitted by the conductor (**10**), ensuring that the intensity of the electric field lines on the sensor (**300**) is independent with respect to the cross-section and to the type of the conductor (**10**).

3. Constructive system according to claim 1 or 2, **characterized by the fact that** said mass of dielectric material (**400**) which incorporates the components (**100, 200, 300)** comprises a through hole (**402/403**) disposed coaxially with respect to the longitudinal axis (**Y**) of the constructive system.

4. Constructive system according to claim 3, **characterized by the fact that** within said through hole (**402/403**) the live element (**10**) is positioned in an axial position.

5. Constructive system according to one of the preceding claims, **characterized in that** said first tubular element (**100**) is provided with first through holes (**101**) which have a width such as to allow passage of the resin through said first through holes (**101**) during the casting operations of the resin.

6. Constructive system according to one of the preceding claims, **characterized by the fact that** said second tubular element (**200**) is provided with second through holes (**201**) which have a width such as to allow passage of the resin through said second through holes (**202**) during the casting operations of the resin.

7. Constructive system according to one of the preceding claims, **characterized by the fact that** said electric field sensor (**300**) is provided with through holes (**301**) which have a such width as to allow passage of the resin through said through holes (**301**) during the casting operations of the resin.

8. Constructive system according to one of the preceding claims, **characterized by the fact that** said electric field sensor (**300**) comprises at least a first inner lamina (**302**) and a second external lamina (**303**) superimposed and joined together; **wherein** said first inner lamina (**302**) is made of an electrically conductive material; **wherein** said second external lamina (**303**) is made of an electrically insulating material and is jointed with respect to the inner face of the second shielding tubular element (**200**).

9. Constructive system according to one of the preceding claims, **characterized by the fact that** said second outer layer (**303**) made of insulating material has technical characteristics such as to electrically isolate the inner lamina (**302**) of the electric field sensor with respect to the second shielding tubular element (**200**).

10. Constructive system according to one of the preceding claims, **characterized by the fact that** said electric field sensor (**300**) is made of a copper-plated glass sheet or a similar element.

11. Constructive system according to one of the preceding claims, **characterized by the fact that** it further comprises a lid element (**500**) in the manner of an upside-down cup equipped with a through axial hole and is applied in an electrically conductive manner near the distal portion of the first tubular element (**100**) with the through hole disposed coaxially with respect to the longitudinal axis (**Y**).

12. Constructive system according to one of the preceding claims, **characterized by the fact that** it further comprises a cable terminal (**600**), **wherein** said cover element (**500**) has coupling means (**502**) suitable for coupling in a conductive manner with a cable terminal **(600),** which is intended to couple in a conductive manner with the live element (**10**).

13. Constructive system according to one of the preceding claims, **characterized by the fact that** it further comprises an electrically shielded compartment (**403**) formed into the mass of dielectric material (**400**).

14. Constructive system according to one of the preceding claims, **characterized by the fact that** it further comprises a Rogowsky coil (**700**) which has its axis positioned coaxially with respect to the longitudinal axis (**Y**) of the construction system.

15. Constructive system according to claim 14, **characterized by the fact that** said Rogowsky coil (**700**) comprises an external shield connected to ground and is positioned inside the second tubular element (**200**) and axially between said electric field sensor (**300**) and the proximal end of the second tubular element (**200**).

## Patentansprüche

1. Konstruktionssystem zur Bestimmung des Wertes der Spannung eines unter Spannung stehenden Elementes (10), wobei sich das System entlang einer Längsachse (Y) erstreckt und bezüglich dieser Längsachse (Y) ein vicinales Ende und ein distales Ende hat, umfassend ein erstes rohrförmiges Element (100), ein zweites rohrförmiges Element (200), einen elektrischen Feldsensor (300) und eine dielektrische Masse (400), wobei das erste rohrförmige Element (100) die Funktion einer Source-Elektrode hat und mittels einer leitenden Kupplung mit dem unter Spannung stehenden Element (10) verbunden ist, während das zweite rohrförmige Element (200) die Funktion einer Abschirmelektrode hat und geerdet oder an ein bekanntes Potential angeschlossen ist, wobei ferner der elektrische Feldsensor (300) zur Ermittlung des von dem ersten rohrförmigen Element (100) erzeugten elektrischen Feldes dient und die dielektrische Masse (400) zur Einbettung und Positionierung der genannten Elemente (100, 200, 300) untereinander vorgesehen ist, wobei ferner das erste rohrförmige Element (100) und das zweite rohrförmige Element (200) koaxial zu der Längsachse (Y) ausgerichtet sind und der elektrische Feldsensor (300) zwischen den beiden rohrförmigen Elementen (100, 200) angeordnet und gegen das erste rohrförmige Element (100) und das zweite rohrförmige Element (200) elektrisch isoliert ist.

2. Konstruktionssystem nach Anspruch 1, **dadurch gekennzeichnet, dass** das erste rohrförmige Element (100) auch die Funktion einer Schirmelektrode zum Abschirmen des elektrischen Feldsensors (300) gegen die Feldlinien des von dem Leiter (10) erzeugten elektrischen Feldes hat, um sicherzustellen, dass die Stärke der elektrischen Feldlinien auf den Sensor (300) unabhängig von dem Querschnitt und der Bauart des Leiters (10) ist.

3. Konstruktionssystem nach Anspruch 1 oder 2, **dadurch gekennzeichnet, dass** die dielektrische Masse (400), welche die Komponenten (100, 200, 300) einschließt, eine Durchgangsbohrung (402/403) hat, die koaxial zur Längsachse (Y) des Konstruktionssystem verläuft.

4. Konstruktionssystem nach Anspruch 3, **dadurch gekennzeichnet, dass** das unter Spannung stehende Element (10) in der Durchgangsbohrung (402/403) in axialer Position angeordnet ist.

5. Konstruktionssystem nach einem der vorhergehenden Ansprüche, **dadurch gekennzeichnet, dass** das erste rohrförmige Element (100) erste durchgehende Öffnungen (101) hat, deren Weite den Durchtritt von Harz beim Vergießen erlaubt.

6. Konstruktionssystem nach einem der vorhergehenden Ansprüche, **dadurch gekennzeichnet, dass** das zweite rohrförmige Element (200) zweite durchgehende Öffnungen (201) hat, deren Weite den Durchtritt von Harz beim Vergießen erlaubt.

7. Konstruktionssystem nach einem der vorhergehenden Ansprüche, **dadurch gekennzeichnet, dass** der elektrische Feldsensor (300) durchgehende Öffnungen (301) hat, deren Weite den Durchtritt von Harz beim Vergießen erlaubt.

8. Konstruktionssystem nach einem der vorhergehenden Ansprüche, **dadurch gekennzeichnet, dass** der elektrische Feldsensor (300) wenigstens eine erste Innenschicht (302) und eine diese überdeckende zweite Außenschicht (303) hat, die miteinander verbunden sind, wobei die Innenschicht (302) aus elektrisch leitendem Material und die Außenschicht (303) aus elektrisch isolierendem Material besteht und an der Innenseite des zweiten rohrförmigen Abschirmelementes (200) anliegt.

9. Konstruktionssystem nach einem der vorhergehenden Ansprüche, **dadurch gekennzeichnet, dass** die Außenschicht (303) aus isolierendem Material so ausgebildet ist, dass sie die Innenschicht (302) des elektrischen Feldsensors gegen das zweite rohrförmige Abschirmelement (200) elektrisch isoliert.

10. Konstruktionssystem nach einem der vorhergehenden Ansprüche, **dadurch gekennzeichnet, dass** der elektrische Feldsensor (300) aus einer mit Kupfer beschichteten Glasplatte oder einem gleichwertigen Element besteht.

11. Konstruktionssystem nach einem der vorhergehenden Ansprüche, **gekennzeichnet durch** ein Deckelelement (500) in Form einer kopfstehenden Schale mit einem axialen Durchgangsloch, die elektrisch leitend in der Nähe des distalen Abschnitts des ersten rohrförmigen Elementes (100) so angebracht ist, dass das Durchgangsloch koaxial zu der Längsachse (Y) verläuft.

12. Konstruktionssystem nach einem der vorhergehenden Ansprüche, **dadurch gekennzeichnet, dass** weiterhin ein Kabelanschluss (600) vorgesehen ist und das Deckelelement (500) Kupplungsmittel (502) zur leitenden Verbindung mit dem Kabelanschluss (600) hat, um eine leitende Verbindung mit dem unter Spannung stehenden Element (10) herzustellen.

13. Konstruktionssystem nach einem der vorhergehenden Ansprüche, **dadurch gekennzeichnet, dass** in der dielektrischen Masse (400) ein elektrisch abgeschirmter Raum (403) ausgebildet ist.

14. Konstruktionssystem nach einem der vorhergehenden Ansprüche, **dadurch gekennzeichnet, dass** ferner eine Rogowsky-Spule (700) vorgesehen ist, deren Achse koaxial zur Längsachse (Y) des Konstruktionssystems verläuft.

15. Konstruktionssystem nach Anspruch 14, **dadurch gekennzeichnet, dass** die Rogowsky-Spule (700) ein äußeres, geerdetes Schild hat, das innerhalb des zweiten rohrförmigen Elementes (200) und axial zwischen dem elektrischen Feldsensor (300) und dem proximalen Ende des zweiten rohrförmigen Elementes (200) angeordnet ist.

## Revendications

1. Système de construction pour déterminer la valeur de la tension d'un élément sous tension (10), ledit élément s'étendant le long d'un axe longitudinal (Y) et présentant par rapport audit axe une extrémité vicinale et une exrémité distale, comprenant un premier élément tubulaire (100), un second élément tubulaire (200), un détecteur de champ électrique (300) et une masse diélectrique (400), ledit premier élément tubulaire (100) ayant la fonction d'un électrode de source et étant relié par un dispositif d'accouplement conducteur à l'élément sous tension (10) tandis que ledit second élément tubulaire (200) ayant la fonction d'une électrode de blindage relié à terre ou à un potentiel connu, le détecteur de champ électrique étant prévu pour à détecter le champ électrique généré par le premier élément tubulaire (100), tandis que la masse diélectrique étant prévue pour noyer et positionner lesdits éléments (100, 200, 300) entre eux, le premier élément tubulaire (100) et le second élément tubulaire (200) étant alignés coaxialement à l'axe longitudinal (Y), le détecteur de champ électrique (300) étant positionné entre les deux éléments tubulaires (100, 200) et isolé par rapport au premier élément tubulaire (100) et par rapport au second élément tubulaire (200).

2. Système de construction selon la revendication 1, **caractérisé par le fait que** le premier élément tubulaire (100) a aussi la fonction d'une électrode de blindage pour blinder le détecteur de champ électrique (300) contre les lignes de champ générées par le conducteur (10) de sorte à assurer que l'intensité des lignes de champ par rapport audit détecteur (300) soit indépendante de la section transversale et du type du conducteur (10).

3. Système de construction selon la revendication 1 ou 2, **caractérisé par le fait que** la masse diélectrique (400) incorporant les composants (100, 200, 300) présente un trou de passage (402/403) s'étendant coaxialement à l'axe longitudinal (Y) du système de construction.

4. Système de construction selon la revendication 3, **caractérisé par le fait que** l'élément sous tension (10) est axialement positionné dans le trou de passage (402/403).

5. Système de construction selon une des revendications précédentes, **caractérisé par le fait que** le premier élément tubulaire (100) possède des premiers trous de passage (101) d'une largeur apte à permettant la résine de passer pendant les opérations de coulage.

6. Système de construction selon une des revendications précédentes, **caractérisé par le fait que** le second élément tubulaire (200) possède des seconds trous de passage (201) d'une largeur permettant à la résine de passer pendant les opérations de coulage.

7. Système de construction selon une des revendications précédentes, **caractérisé par le fait que** le détecteur de champ électrique (300) possède des trous de passage (301) d'une largeur permettant à la résine de passer pendant les opérations de coulage.

8. Système de construction selon une des revendications précédentes, **caractérisé par le fait que** ledit détecteur de champ électrique (300) est muni au moins d'une première couche intérieure (302) et d'une seconde couche extérieure (303) superposées et reliées l'une à l'autre, ladite première couche intérieure étant d'un matériau conducteur et ladite seconde couche extérieure étant d'un matériau isolant et reliée à la face intérieure du second élément tubulaire de blindage (200).

9. Système de construction selon une des revendications précédentes, **caractérisé par le fait que** ladite seconde couche extérieure (303) de matériau isolant est apte à isoler électriquement isoler la couche intérieure (302) du détecteur de champ électrique (300) par rapport au second élément tubulaire de blindage (200).

10. Système de construction selon une des revendications précédentes, **caractérisé par le fait que** ledit détecteur de champ électrique est formé d'une plaque de verre recouverte de cuivre ou un élément similaire.

11. Système de construction selon une des revendications précédentes, **caractérisé par le fait qu'**il comprend un élément de couvercle (500) en forme d'une coupe retournée de haut en bas et munie d'un trou de passage axial, l'élément de couvercle (500) étant appliqué de manière conductible près de la portion distale du premier élément tubulaire (100), le trou de passage étant coaxial à l'axe longitudinal (Y).

12. Système de construction selon une des revendications précédentes, **caractérisé par le fait qu'**il comprend en outre un raccord de câble (600), ledit élément de couvercle (500) étant muni de moyens de raccord (502) pour être relié de manière conductible au raccord de câble (600) destinés à l'accouplement conductible avec l'élément sous tension (10).

13. Système de construction selon une des revendications précédentes, **caractérisé par le fait qu'**il comprend en outre un compartiment (403) électriquement blindé et formé dans la masse de matériau diélectrique (400).

14. Système de construction selon une des revendications précédentes, **caractérisé par le fait qu'**il comprend en outre une bobine Rogowsky (700) avec son axe positionné coaxialement par rapport à l'axe longitudinal (Y) du système de construction.

15. Système de construction selon une des revendications précédentes, **caractérisé par le fait que** ladite bobine Rogowsky (700) comprend une plaque extérieure mise à la terre et positionné dans le second élément tubulaire (200) et axialement entre ledit détecteur de champ électrique (300) et l'extrémité proximale du second élément tubulaire (200).
